# EUROPEAN PATENT APPLICATION

(11) **EP 4 827 286 A1**
(43) Date of publication of application: **21.10.2026**
(21) Application number: 25844501.4
(22) Date of filing: 30.01.2025
(51) Int. Cl.: H10K 30/50, B05D 7/24, B32B 9/00, H10K 30/40

(54) **PEROVSKITE FILM FORMING APPARATUS AND PEROVSKITE FILM FORMING METHOD**

(30) Priority: 26.07.2024 JP 2024120739
(71) Applicant: HIRANO TECSEED Co., Ltd., Kitakatsuragi-gun, Nara 636-0051 (JP)
(72) Inventor: TSUDA, Takeaki, Kitakatsuragi-gun, Nara 636-0051 (JP); HIRA, Takanobu, Kitakatsuragi-gun, Nara 636-0051 (JP); INOSE, Koki, Kitakatsuragi-gun, Nara 636-0051 (JP); SASANO, Yushi, Kitakatsuragi-gun, Nara 636-0051 (JP)
(74) Representative: Wallinger Ricker Schlotter PartGmbB
(86) International application number: PCT/JP2025/003042
(87) International publication number: WO 2026/023123

(57) **Abstract**

A perovskite film formation apparatus 10 according to one embodiment crystallizes a perovskite precursor on a base material 1 coated with a solution containing the perovskite precursor and a solvent to form a perovskite film, the perovskite film formation apparatus 10 includes, as areas configured to allow the base material 1 to pass therethrough, a solvent removal chamber 14 serving as an area where the solvent is removed from the solution coated on the base material 1 without crystallizing the perovskite precursor, and a crystallization chamber 15 serving as an area where the perovskite precursor is crystallized on the base material 1 having passed through the solvent removal chamber 14 to form the perovskite film.

## Description

### Technical Field

The present invention relates to a perovskite film formation apparatus and a perovskite film formation method.

### Background Art

In recent years, perovskite solar cells have attracted attention as solar cells that are thin, lightweight, and can be expected to have high power conversion efficiency. The perovskite solar cell is a battery in which solar light is absorbed in a perovskite film, producing free electrons and holes that generate electrical power.

According to a producing method of the perovskite film, first, a base material is coated with a solution. This coating method is a so-called spin coating method in which a solution containing a perovskite precursor and a solvent is deposited onto a base material, and the base material is rotated to spread the solution on the base material. Thereafter, the base material coated with the solution is heated by a hot plate to remove the solvent and crystallize the perovskite precursor to form a perovskite film.

In addition, as described in PTL 1, it has also been proposed that a solution is coated from a moving nozzle toward a base material, the base material after the coating is placed under a reduced pressure environment to volatilize the solvent while proceeding crystallization from a perovskite precursor to a perovskite (that is, perovskite formation), and then the base material is placed under a heating environment to further proceed the perovskite formation.

### Citation List

### Patent Literature

PTL 1: JP2024-14771A

### Summary of Invention

### Technical Problem

However, in each of the above methods, the evaporation of the solvent and the perovskite formation proceed simultaneously. This causes a non-uniform crystalline state leading to a decrease in the power conversion efficiency, and formation of defects (voids) causing a short circuit. In the current situation, it is difficult to form a high-quality perovskite film in this way, posing an obstacle to the widespread adoption of perovskite solar cells.

In addition, attempts have also been made to improve the quality of the perovskite film by devisal measures related to the solution, such as a method of adding an ionic liquid to a solution containing a perovskite precursor or an anti-solvent method of dropping a poor solvent into a solution on a base material during spin coating. However, each of these methods is a formation method in a university experiment stage or a company research and development stage and is not a method for mass-producing the perovskite film necessary for spreading the perovskite solar cell.

The present invention has been made in view of the foregoing circumstances, and an object of the present invention is to provide an apparatus and a method capable of mass-producing a high-quality perovskite film.

### Solution to Problem

A perovskite film formation apparatus according to one embodiment refers to a perovskite film formation apparatus that crystallizes a perovskite precursor on a base material coated with a solution containing the perovskite precursor and a solvent to form a perovskite film, the perovskite film formation apparatus includes, as areas configured to allow the base material to be continuously conveyed to pass therethrough, a solvent removal chamber serving as an area where the solution on the base material is heated to a temperature at which the solvent is evaporated and the perovskite precursor is not crystallized, thereby removing the solvent from the solution coated on the base material without crystallizing the perovskite precursor; and a crystallization chamber serving as an area where the perovskite precursor is crystallized, on the base material having passed through the solvent removal chamber and from which the solvent is removed, by being heated to a crystallization temperature or higher to form the perovskite film.

Further, a perovskite film formation method according to one embodiment refers to a perovskite film formation method that crystallizes a perovskite precursor on a base material coated with a solution containing the perovskite precursor and a solvent to form a perovskite film, the perovskite film formation method includes a step of heating the solution on the base material to a temperature at which the solvent is evaporated and the perovskite precursor is not crystallized, thereby removing the solvent from the solution coated on the base material without crystallizing the perovskite precursor; and a step of crystallizing the perovskite precursor, on the base material from which the solvent is removed, by heating the perovskite precursor to a crystallization temperature or higher to form the perovskite film, after the step of removing the solvent.

### Advantageous Effects of Invention

According to the perovskite film formation apparatus described above, by allowing the base material to sequentially pass through the solvent removal chamber and the crystallization chamber, a high-quality perovskite film can be formed, and mass production thereof can also be achieved. In addition, according to the perovskite film formation method described above, by crystallizing the perovskite precursor after removing the solvent from the solution coated on the base material, the high-quality perovskite film can be formed, and the mass production thereof can also be achieved.

### Brief Description of Drawings

[FIG. 1] FIG. 1 is a side view of a perovskite film formation apparatus.
[FIG. 2] FIG. 2 is a side view of a base material coated with a solution.
[FIG. 3] FIG. 3 is a side view of a solvent removal chamber.
[FIG. 4] FIG. 4 is a side view of a crystallization chamber.
[FIG. 5] FIG. 5 is a block diagram of the perovskite film formation apparatus.

### Description of Embodiments

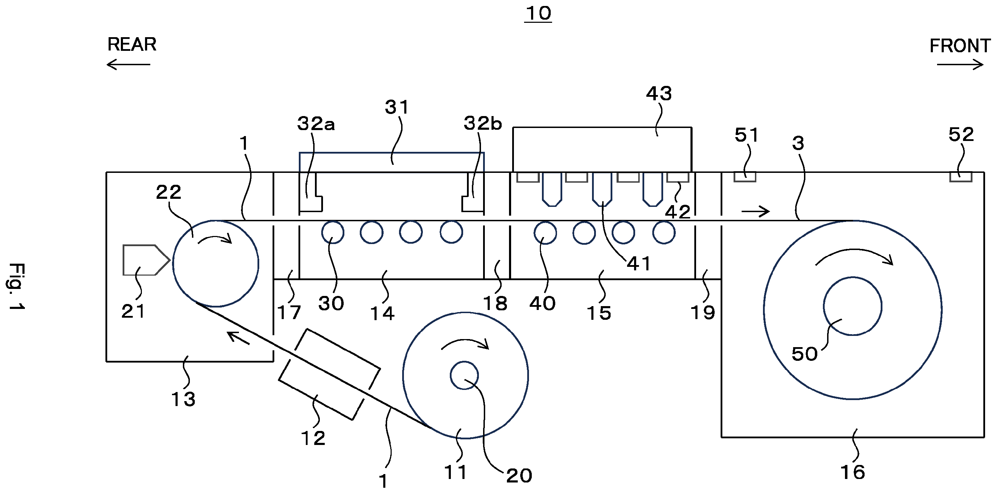

A perovskite film formation apparatus 10 according to one embodiment of the present invention will be described with reference to FIGS. 1 to 5. In the following description, an advancing direction side of an elongated base material 1 is referred to as a front direction, and an opposite side is referred to as a rear direction. In addition, left and right directions refer to left and right directions when the rear direction is viewed from the front direction.

### (1) Overall Configuration of Perovskite Film Formation Apparatus 10

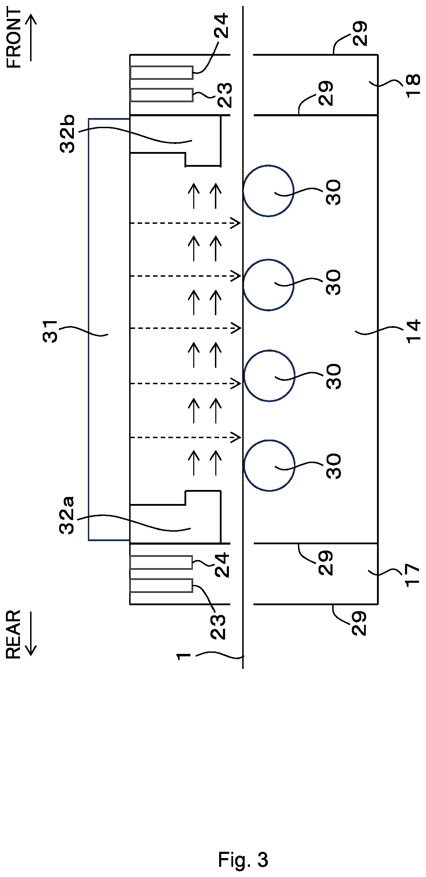

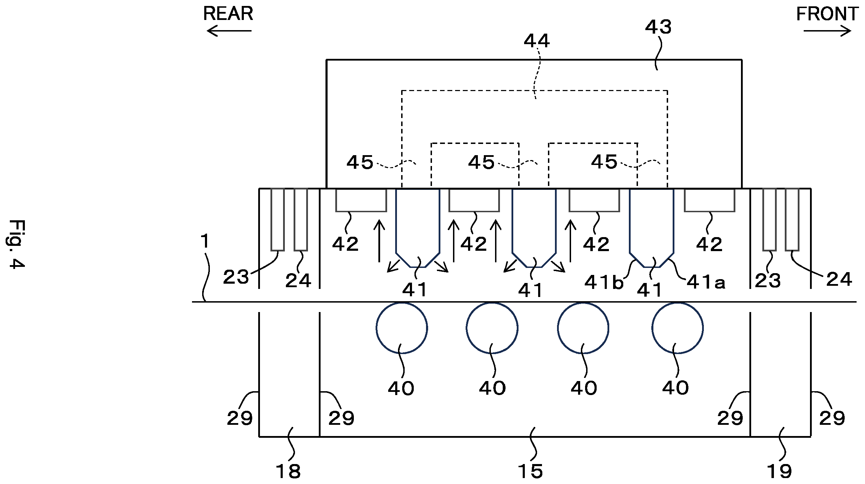

As shown in FIG. 1, in the perovskite film formation apparatus 10, a coating chamber 13, a solvent removal chamber 14, a crystallization chamber 15, and an annealing chamber 16 are arranged from the rear direction to the front direction. A first pressure adjustment chamber 17 is provided between the coating chamber 13 and the solvent removal chamber 14, a second pressure adjustment chamber 18 is provided between the solvent removal chamber 14 and the crystallization chamber 15, and a third pressure adjustment chamber 19 is provided between the crystallization chamber 15 and the annealing chamber 16. Partition walls 29 (see FIGS. 3 and 4) each provided with an opening through which the base material 1 can pass, partition the pressure adjustment chambers 17, 18, and 19 and adjacent regions in the front-rear direction. The perovskite film formation apparatus 10 also includes an unwinding unit 11 and a surface treatment unit 12.

### (2) Configurations of Unwinding Unit 11 and Surface Treatment Unit 12

The unwinding unit 11 is provided with a winding shaft 20. The base material 1 before a solution is coated is wound around the winding shaft 20. The winding shaft 20 is driven by a motor to rotate and unwind the base material 1. The base material 1 before the solution is coated is obtained by laminating a transparent conductive film and an electron transport layer on a transparent film such as a polyethylene terephthalate film. The width of the base material 1 is, for example, 200 mm to 1000 mm.

The surface treatment unit 12 is a unit that performs a surface treatment on the base material 1 conveyed from the unwinding unit 11. The surface treatment is a treatment for improving the wettability of the electron transport layer of the base material 1, and is, for example, any one of a corona treatment, a plasma treatment, a UV treatment, and the like. The surface treatment unit 12 also removes dust from the base material 1.

### (3) Configuration of Coating Chamber 13

In the coating chamber 13, a die 21 and a backup roller 22 in front of the die 21 are provided. The backup roller 22 is one of rollers that convey the base material 1, and is rotated by driving of a motor. A rotation shaft of the backup roller 22 extends in a left-right direction. The base material 1 conveyed from the surface treatment unit 12 located below the backup roller 22 is changed in a conveyance direction at the backup roller 22 and is conveyed forward. In the vicinity of the die 21, the backup roller 22 conveys the base material 1 from the bottom to the top.

The die 21 deposits the solution on the base material 1 in contact with the backup roller 22 and coats the entire base material 1 with the solution in a width direction (the left-right direction) with a preset coating thickness. A surface of the base material 1 onto which the solution is coated is an upper surface in the solvent removal chamber 14 and the crystallization chamber 15.

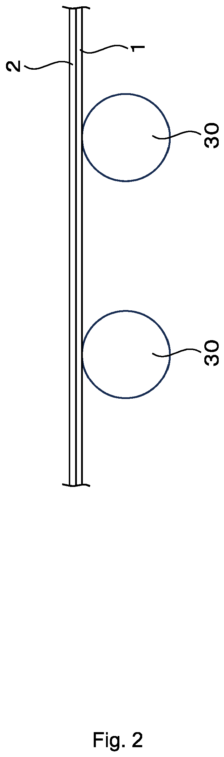

For reference, FIG. 2 shows a state in which a solution layer 2 is formed by coating the solution onto the base material 1. FIG. 2 is a view showing the base material 1 immediately after entering the solvent removal chamber 14. In the present specification, the base material 1 onto which the solution is coated may also be simply referred to as the "base material 1".

The solution contains a perovskite precursor and a solvent. The perovskite precursor is a material at a stage before being crystallized into a perovskite. For example, in the case of attempting to generate methylammonium lead iodide CH₃NH₃PbI₃ as the perovskite, lead iodide PbI₂ and methylammonium iodide CH₃NH₃I are used as the perovskite precursor. A wavelength of an infrared ray to be absorbed by the solvent is clear, for example, the solvent absorbs an infrared ray having a wavelength of 10 µm or less. Wavelengths of infrared rays to be absorbed by the solvent and the perovskite precursor are different from each other. The difference between the wavelengths of the infrared rays to be absorbed means that infrared absorption spectra are different. Specific examples of the solvent include N,N-dimethylformamide (DMF) and dimethyl sulfoxide (DMSO).

### (4) Configuration of Solvent Removal Chamber 14

The solvent removal chamber 14 is shown in FIG. 3. The solvent removal chamber 14 has a rectangular parallelepiped external shape, has a heat-insulating property, and is separated from other areas. The solvent removal chamber 14 has a carry-in port for the base material 1 on a rear surface, and a carry-out port for the base material 1 on a front surface. In the solvent removal chamber 14, a plurality of conveyance rollers 30 are arranged along a front-rear direction. The conveyance rollers 30 are rotated by driving of a motor. A rotation shaft of each conveyance roller 30 extends in the left-right direction. The conveyance rollers 30 allow the base material 1 to be placed thereon and convey the base material 1. Each conveyance roller 30 also plays a role in keeping the base material 1 horizontal so that the coated solution does not flow.

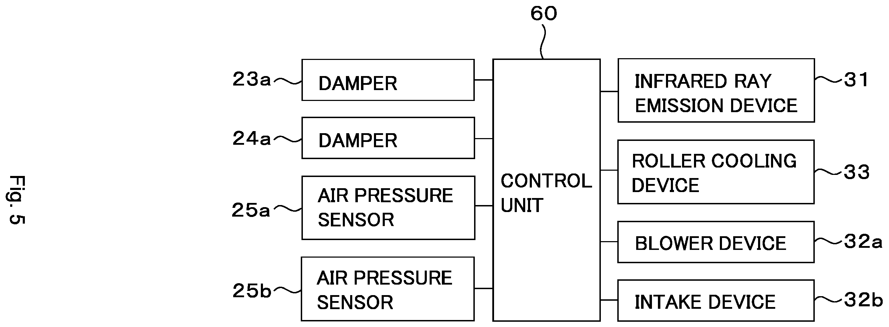

A roller cooling device 33 (see FIG. 5) that cools at least outer peripheral surfaces of the plurality of conveyance rollers 30 is provided. Although not shown, the roller cooling device 33 includes fluid flow paths formed inside the conveyance rollers 30 and a circulation device for circulating a fluid (for example, water or air) through the flow paths. Alternatively, the roller cooling device 33 includes Peltier elements provided in the respective conveyance rollers 30 and a power supply for energizing the Peltier elements.

The roller cooling device 33 cools the conveyance rollers 30, thereby cooling the base material 1 (see FIG. 2) placed on the conveyance rollers 30 from a lower surface side. As described below, in the solvent removal chamber 14, the solvent is evaporated from the solution layer 2 on the base material 1, and at this time, latent heat of evaporation is taken from a surface (an upper surface) of the solution layer 2. The roller cooling device 33 has a cooling capacity that is set such that the cooled conveyance rollers 30 can take, from a base material 1 side, the same amount of heat as the latent heat taken at this time.

One infrared ray emission device 31 is provided at a location above the conveyance rollers 30 in the solvent removal chamber 14. The infrared ray emission device 31 is a device that emits an infrared ray having a wavelength, which is absorbed by the solvent and is less likely to be absorbed by the perovskite precursor. When a solvent that absorbs an infrared ray with a wavelength of 10 µm or less is used, the infrared ray emission device 31 is configured to emit an infrared ray with a wavelength of 10 µm or less. The infrared ray emission device 31 that emits an infrared ray within such a specific wavelength range is realized by combining a device that emits an infrared ray over a broader wavelength range with a filter that transmits only an infrared ray within the specific wavelength range (e.g., a low-pass filter that transmits only an infrared ray having a wavelength of 10 µm or less).

The infrared ray emission device 31 is sufficiently large in the front-rear direction and the left-right direction (for example, is formed in a planar shape), and can emit the infrared ray over a wide range in the front-rear direction and the entire left-right direction (the width direction) of the base material 1. The length of the infrared ray emission device 31 in the left-right direction is preferably long within a range in which the infrared ray can be uniformly emitted to the base material 1, for example, preferably longer than the length of the base material 1 in the left-right direction, and more preferably longer than the length of the conveyance rollers 30 in the left-right direction.

The infrared ray from such an infrared ray emission device 31 is emitted onto the base material 1 as indicated by broken-line arrows in FIG. 3, and the solvent in the solution is evaporated by radiation. Due to the emission of the infrared ray, the solution has a temperature that becomes higher than an ambient temperature in the solvent removal chamber 14 (for example, around 70°C), but the temperature does not rise to a temperature at which the perovskite precursor is crystallized (for example, around 100°C).

The ambient temperature in the solvent removal chamber 14 is a temperature sufficiently lower than the temperature at which the perovskite precursor is crystallized to obtain the perovskite, and is, for example, 30°C to 50°C.

A rectifying device is provided at a location above the conveyance rollers 30 in the solvent removal chamber 14. The rectifying device includes a blower device 32a that blows air and an intake device 32b that draws in the air. The blower device 32a is provided at a location above and behind the conveyance rollers 30 in the solvent removal chamber 14, and blows the air forward and horizontally. The intake device 32b is provided at a location at the same height as and in front of the blower device 32a in the solvent removal chamber 14, and intakes the air blown from behind.

With the arrangement of the blower device 32a and the intake device 32b, the air is sent from the blower device 32a toward the intake device 32b as indicated by solid-line arrows in FIG. 3. Therefore, the air flows above the base material 1 on the conveyance rollers 30 in the same direction as the conveyance direction of the base material 1. A speed of an air flow is controlled to be the same as a conveyance speed of the base material 1. The air blown from the blower device 32a has a temperature that is the same as a temperature of air in the solvent removal chamber 14, and is, for example, 30°C to 50°C.

### (5) Configuration of Crystallization Chamber 15

FIG. 4 shows the crystallization chamber 15. The crystallization chamber 15 has a rectangular parallelepiped external shape, has a heat-insulating property, and is separated from other areas. The crystallization chamber 15 has a carry-in port for the base material 1 on a rear surface, and a carry-out port for the base material 1 on a front surface. In the crystallization chamber 15, a plurality of conveyance rollers 40 are arranged in the front-rear direction. The conveyance rollers 40 are rotated by driving of a motor. A rotation shaft of each conveyance roller 40 extends in the left-right direction. The conveyance rollers 40 allow the base material 1 to be placed thereon and convey the base material 1.

In the crystallization chamber 15, a plurality of nozzles 41 are arranged in the front-rear direction above the conveyance rollers 40. These nozzles 41 blow hot air to the base material 1 conveyed by the conveyance rollers 40, heat the base material 1 to a temperature (for example, around 100°C) or higher at which the perovskite precursor is crystallized, so as to perform crystallization. The inside of each nozzle 41 is a flow path for the hot air that extends in an up-down direction. A front outlet 41a and a rear outlet 41b are formed in a lower portion of each nozzle 41. The front outlet 41a is an outlet that blows the hot air in the nozzle 41 forward and obliquely downward. The rear outlet 41b is an outlet that blows the hot air in the nozzle 41 rearward and obliquely downward.

Inlets 42 for drawing in the hot air from within the crystallization chamber 15 are provided above the conveyance rollers 40. The inlets 42 and the nozzles 41 are alternately arranged in the front-rear direction, and the inlet 42 is disposed between the adjacent nozzles 41. Each inlet 42 is provided at a location higher than the front outlet 41a and the rear outlet 41b of each nozzle 41. With such a structure, the hot air injected obliquely downward from the front outlets 41a and the rear outlets 41b of the nozzles 41 rises in a relatively short time and is drawn into the inlets 42. The flow of the hot air is indicated by arrows in FIG. 4. Due to such a flow of the hot air, it is difficult for the hot air to leak out of the crystallization chamber 15.

All the nozzles 41 and all the inlets 42 are provided not on a side surface but on a ceiling of the crystallization chamber 15. Therefore, in the crystallization chamber 15, the flow of the hot air is less likely to occur in the left-right direction, and a temperature change is less likely to occur in the left-right direction.

The width (the length in the left-right direction) of each of the front outlet 41a, the rear outlet 41b, and the inlet 42 is substantially the same as the length of the conveyance roller 40 in the left-right direction, and is, for example, 100% to 120% with respect to the length of the conveyance roller 40 in the left-right direction. Accordingly, the entire crystallization chamber 15 in the width direction (the left-right direction) is easily heated uniformly. The structure of the nozzle 41 is not limited to this structure, and may be any structure that uniformly heats the base material 1.

The entire crystallization chamber 15 is maintained at a substantially uniform temperature. The ambient temperature in the crystallization chamber 15 is a temperature at which the perovskite precursor is crystallized, and is, for example, around 100°C.

An air exhaust chamber 43 communicating with the inlets 42 is provided above the crystallization chamber 15. An air supply chamber 44 is provided by being surrounded by the air exhaust chamber 43, and an air supply path 45 is provided from the air supply chamber 44 to each nozzle 41. The air taken in from the outside of the perovskite film formation apparatus 10 is heated by a heater (not shown), passes through the air supply chamber 44, the air supply paths 45, and the nozzles 41, and is blown out into the crystallization chamber 15. The air drawn in from the inlets 42 passes through the air exhaust chamber 43 and is discharged to the outside of the perovskite film formation apparatus 10.

### (6) Configuration of Annealing Chamber 16

As shown in FIG. 1, the annealing chamber 16 is provided with an intake port 51 for supplying the hot air heated by the heater into the annealing chamber 16, and a discharge port 52 for discharging the air in the annealing chamber 16 to the outside of the annealing chamber 16. By the hot air supplied from the intake port 51, an ambient temperature in the annealing chamber 16 is maintained at a temperature lower than the temperature of the crystallization chamber 15 and higher than an ordinary temperature. The ordinary temperature is a surrounding temperature of the perovskite film formation apparatus 10 in an operating state of the perovskite film formation apparatus 10.

A dehumidifier (not shown) is provided in the annealing chamber 16. The dehumidifier controls a humidity of the annealing chamber 16 to, for example, 30% or less. It is preferable that a dehumidifier is also provided in each of the coating chamber 13, the solvent removal chamber 14, and the crystallization chamber 15, and respective humidities thereof are controlled to be, for example, 30% or less.

The annealing chamber 16 is also a winding unit that winds a perovskite film laminate 3 in which a perovskite film is formed on the base material 1. A winding shaft 50 is disposed in this winding unit. The winding shaft 50 is rotated by driving of a motor, and winds the perovskite film laminate 3.

### (7) Configurations of Pressure Adjustment Chambers 17, 18, 19

The second pressure adjustment chamber 18 between the solvent removal chamber 14 and the crystallization chamber 15 will be described. As shown in FIG. 4, the second pressure adjustment chamber 18 is provided with an air supply port 23 and an air exhaust port 24. Dampers 23a and 24a (see FIG. 5) are respectively provided in ducts communicating with the air supply port 23 and the air exhaust port 24, and an amount of air supplied from the air supply port 23 and an amount of air exhausted from the air exhaust port 24 can be controlled by controlling the dampers 23a and 24a. The duct may be provided with a fan.

Air pressure sensors 25a and 25b (see FIG. 5) each for measuring an air pressure are respectively provided in the solvent removal chamber 14 and the crystallization chamber 15 serving as the adjacent areas of the second pressure adjustment chamber 18.

A control unit 60 to be described next constantly monitors a difference between an air pressure in the solvent removal chamber 14 and an air pressure in the crystallization chamber 15 that are respectively measured by the air pressure sensors 25a and 25b. Then, when there is the difference in the air pressure between the two areas (that is, the solvent removal chamber 14 and the crystallization chamber 15) or when the difference in the air pressure between the two areas is equal to or larger than a predetermined value, the control unit 60 controls the dampers 23a and 24a to supply or exhaust the air to or from the second pressure adjustment chamber 18, thereby substantially eliminating the difference in the air pressure between the two areas. For example, when the control unit 60 causes the air to be supplied to the second pressure adjustment chamber 18, the air supplied from the outside to the second pressure adjustment chamber 18 flows into one of the two areas that has a lower air pressure, and the difference in the air pressure between the two areas is substantially eliminated. Further, when the control unit 60 causes the air to be exhausted from the second pressure adjustment chamber 18, the air in the area having a higher air pressure of the two areas passes through the second pressure adjustment chamber 18 and is exhausted to the outside, and the difference in the air pressure between the two areas is substantially eliminated.

Since the difference in the air pressure between the solvent removal chamber 14 and the crystallization chamber 15 is substantially eliminated, the air flow between the solvent removal chamber 14 and the crystallization chamber 15 is hardly generated, and conditions such as temperature are maintained in each of the solvent removal chamber 14 and the crystallization chamber 15.

The first pressure adjustment chamber 17 and the third pressure adjustment chamber 19 have the same structure as the second pressure adjustment chamber 18, and are controlled in the same manner as the second pressure adjustment chamber 18. Accordingly, the air flow is less likely to be generated between the adjacent areas of each of the pressure adjustment chambers 17 and 19, and the conditions such as temperature are maintained in these areas.

### (8) Electrical Configuration of Perovskite Film Formation Apparatus 10

The perovskite film formation apparatus 10 includes the control unit 60 composed of a computer. As shown in FIG. 5, the infrared ray emission device 31, the roller cooling device 33, the blower device 32a, the intake device 32b, the dampers 23a and 24a, and the air pressure sensors 25a and 25b are connected to the control unit 60. Although not shown, the motors for rotating the various rollers, the heater for heating the air, and the like are also connected to the control unit 60. The control unit 60 controls the connected devices.

### (9) Perovskite Film Formation Method

In the present embodiment, one elongated base material 1 is unwound from the winding shaft 20 in the unwinding unit 11 on one side, and is wound around the winding shaft 50 in the annealing chamber 16 on the other side. Accordingly, the base material 1 is continuously conveyed in the order of the coating chamber 13, the first pressure adjustment chamber 17, the solvent removal chamber 14, the second pressure adjustment chamber 18, the crystallization chamber 15, the third pressure adjustment chamber 19, and the annealing chamber 16. The conveyance speed of the base material 1 from the unwinding unit 11 to the annealing chamber 16 is appropriately adjusted, and is, for example, 5 to 20 m/min.

In the coating chamber 13, the solution is deposited from the die 21 toward the base material 1 in contact with the backup roller 22, and the solution is coated onto the surface of the base material 1 on an electron transport layer side (the surface opposite to a film side).

In the solvent removal chamber 14, the base material 1 is conveyed on the plurality of conveyance rollers 30. In the solvent removal chamber 14, the surface of the base material 1 on which the solution is coated faces upward. Thereafter, the base material 1 is conveyed horizontally while the surface coated with the solution faces upward until immediately before being wound around the winding shaft 50 in the annealing chamber 16.

The infrared ray having the wavelength that is absorbed by the solvent and is less likely to be absorbed by the perovskite precursor, is emitted from the infrared ray emission device 31 located above to the base material 1 being conveyed in the solvent removal chamber 14. Accordingly, the solvent in the solution is evaporated by radiation and is removed from the base material 1. The temperature of the solution rises to a temperature at which the solvent is evaporated (for example, around 70°C) due to the emission of the infrared ray, but does not rise to the temperature at which the perovskite precursor is crystallized (for example, around 100°C). Therefore, the perovskite is not generated in the solvent removal chamber 14.

When the solvent is evaporated, the latent heat of evaporation is taken from the solution, and the temperature of the surface (the upper surface) of the solution layer 2 decreases. If the temperature on the base material 1 side is high even though the temperature of the surface decreases in the solution layer 2, convection occurs in the solution, and Benard cells are generated. When the perovskite precursor is crystallized in a state in which the Benard cells are generated, cell boundaries become crystal grain boundaries, and cracks are likely to occur at the crystal grain boundaries. The term "Benard cells" refers to a regularly divided cell-like convection structure that is generated when a thin layered fluid is uniformly heated from below.

However, in the solvent removal chamber 14 of the present embodiment, the conveyance rollers 30 are cooled by the roller cooling device 33, and the base material 1 is cooled from the lower surface side by the conveyance rollers 30. As a result, the temperature of the surface is substantially equal to the temperature on the base material 1 side in the solution layer 2, and the convection is less likely to occur in the solution.

On the base material 1 being conveyed in the solvent removal chamber 14, the air controlled to have the same speed as the conveyance speed of the base material 1 is blown in the same direction as the conveyance direction of the base material 1 by the rectifying device. Accordingly, convection of the air is less likely to occur above the solution layer 2 on the base material 1, and unevenness as wind ripples is less likely to be formed on the solution layer 2. Further, there is also an effect that the evaporated solvent is drawn into the intake device 32b together with the air from the blower device 32a, and is discharged to the outside of the solvent removal chamber 14.

In the crystallization chamber 15, the base material 1 from which the solvent is removed is conveyed on the plurality of conveyance rollers 40. During the conveyance, the perovskite precursor is heated and crystallized to obtain the perovskite on the base material 1 by the hot air from the nozzles 41, and the perovskite film is formed. At this time, since the base material 1 from which the solvent is removed is conveyed, the evaporation of the solvent and perovskite formation do not proceed simultaneously, a uniform crystalline state is obtained, and defects (voids) causing a short circuit are less likely to be formed. In addition, since the convection is less likely to occur in the solution on the base material 1 as described above, and the temperature of the entire crystallization chamber 15 is substantially uniform, the perovskite film having uniform quality is formed on the entire base material 1.

In the annealing chamber 16, the perovskite film laminate 3 in which the perovskite film is formed on the base material 1 is wound around the winding shaft 50, and finally has a large roll shape. The perovskite film is heated from when the perovskite film laminate 3 enters the annealing chamber 16 to when the rolled perovskite film laminate 3 is taken out from the annealing chamber 16. A stress in the perovskite film is relaxed by the heating in the annealing chamber 16. Since the annealing chamber 16 has a lower temperature than that of the crystallization chamber 15, the perovskite film laminate 3 is not rapidly cooled when taken out from the annealing chamber 16, and the cracks are less likely to occur in the perovskite film.

The perovskite film laminate 3 taken out from the annealing chamber 16 is conveyed to another apparatus. Further, in the apparatus, a positive-hole transport layer and electrodes are laminated on the perovskite film in the perovskite film laminate 3 to form a perovskite solar cell.

### (10) Effects

The perovskite film formation apparatus 10 of the present embodiment includes the solvent removal chamber 14 serving as the area where the solvent is removed from the solution coated onto the base material 1 without crystallizing the perovskite precursor, and the crystallization chamber 15 serving as the area where the perovskite precursor is crystallized on the base material 1 having passed through the solvent removal chamber 14 to form the perovskite film. Therefore, it is possible to prevent the removal of the solvent and the crystallization of the perovskite from simultaneously proceeding, and it is possible to form a high-quality perovskite film having a uniform crystal structure and few defects. In addition, since the perovskite film can be formed by causing the base material 1 to sequentially pass through the solvent removal chamber 14 and the crystallization chamber 15, the perovskite film can be continuously produced, and mass production thereof can be achieved.

Since the perovskite film has the high quality as described above, the perovskite solar cell has high power conversion efficiency and high durability. Further, since the high-quality perovskite film can be formed, the yield during the mass production is improved. Since the above lead to the spread of the perovskite solar cell, it is expected to reduce power generation using fossil fuels and emission of carbon dioxide associated therewith.

In addition, the perovskite film formation apparatus 10 is provided with the unwinding unit 11 that unwinds the base material 1 before the solution is coated, and the winding unit (the annealing chamber 16) that winds the perovskite film laminate 3 in which the perovskite film is formed on the base material 1, and the coating chamber 13, the solvent removal chamber 14, and the crystallization chamber 15 are provided between the unwinding unit 11 and the winding unit. Accordingly, one elongated base material 1 is unwound from the unwinding unit 11 on one side, and is wound around the winding unit on the other side. Further, during the conveyance of the base material 1 from the unwinding unit 11 to the winding unit as described above, the coating of the solution onto the base material 1, the removal of the solvent from the solution, and the crystallization of the perovskite precursor can be performed. Therefore, the perovskite film laminate 3 can be mass-produced more efficiently.

In addition, the solvent removal chamber 14 is provided with the infrared ray emission device 31 that emits the infrared ray having the wavelength which is absorbed by the solvent and is less likely to be absorbed by the perovskite precursor, and the infrared ray emission device 31 emits the infrared ray toward the solution. Accordingly, the solvent is removed by heating the solution to the temperature at which the solvent can be evaporated and the perovskite precursor is not crystallized. Therefore, the solvent can be removed from the solution without raising the temperature of the perovskite precursor to the temperature for the crystallization, and the removal of the solvent and the crystallization can be prevented from simultaneously proceeding.

Further, the solvent removal chamber 14 is provided with the conveyance rollers 30 for allowing the base material 1 to be placed thereon and convey the base material 1, and the roller cooling device 33 for cooling the conveyance rollers 30, and the conveyance rollers 30 convey the base material 1 with the surface coated with the solution facing upward. Therefore, the base material 1 can be cooled from the lower surface side by cooling the conveyance rollers 30, and the temperature on the base material 1 side in the solution layer 2 can be lowered. Accordingly, even when the temperature of the surface (the upper surface) in the solution layer 2 decreases due to the evaporation of the solvent, it is possible to prevent the occurrence of the convection due to the occurrence of a temperature difference in the solution layer 2, and to prevent the occurrence of the Benard cells and the occurrence of the cracks due to the Benard cells.

In addition, in the solvent removal chamber 14, since the rectifying device for blowing the air is provided above the conveyance rollers 30, it is possible to rectify the air flow above the solution layer 2 on the base material 1, and to prevent the unevenness from being formed on the solution layer 2. Here, since the direction of the air blown by the rectifying device is the same as the conveyance direction of the base material 1, the unevenness as the wind ripples is less likely to be formed on the solution layer 2.

In addition, the second pressure adjustment chamber 18 is provided between the solvent removal chamber 14 and the crystallization chamber 15, and the difference between the air pressure in the solvent removal chamber 14 and the air pressure in the crystallization chamber 15 is controlled to be eliminated by the intake and exhaust in the second pressure adjustment chamber 18. Therefore, there is almost no difference between the air pressure in the solvent removal chamber 14 and the air pressure in the crystallization chamber 15, the air flow is less likely to occur between the crystallization chamber 15 and the solvent removal chamber 14, and the conditions such as temperature are maintained in each of the crystallization chamber 15 and the solvent removal chamber 14. For example, a situation is less likely to occur in which the high-temperature air in the crystallization chamber 15 flows into the solvent removal chamber 14, the temperature of the solvent removal chamber 14 becomes high, and the perovskite precursor is crystallized in the solvent removal chamber 14.

In addition, since the pressure adjustment chambers 17 and 19 are also respectively provided between the coating chamber 13 and the solvent removal chamber 14 and between the crystallization chamber 15 and the annealing chamber 16, the air is also less likely to move between the coating chamber 13 and the solvent removal chamber 14 and between the crystallization chamber 15 and the annealing chamber 16, and the temperature or the like of each area is maintained at an appropriate value.

Further, in the crystallization chamber 15, the base material 1 conveyed by the conveyance rollers 40 can be heated to the temperature equal to or higher than the temperature at which the perovskite precursor is crystallized, by blowing the hot air thereto, so as to perform the crystallization. Since the base material 1 from which the solvent is removed is conveyed to the crystallization chamber 15, the evaporation of the solvent and the perovskite formation do not proceed simultaneously, and when the perovskite precursor is crystallized due to the hot air from the nozzles 41 to form the perovskite film, the uniform crystalline state is obtained, and the defects (the voids) causing a short circuit are less likely to be formed.

In the crystallization chamber 15, since the plurality of nozzles 41 each including the outlets 41a and 41b for the hot air are arranged in the front-rear direction, and the inlets 42 for the air are provided between the adjacent nozzles 41, the hot air injected from the outlets 41a and 41b is drawn into the inlets 42 and discharged in a relatively short time. Therefore, the temperature rise due to the hot air is local, and the temperature of the hot air is less likely to be transmitted to the solvent removal chamber 14. For this reason, it is possible to prevent the perovskite precursor from being crystallized in the solvent removal chamber 14.

In addition, since the annealing chamber 16 is provided as the area where the base material 1 having passed through the crystallization chamber 15 reaches, the stress of the crystallized perovskite can be relaxed. Here, since the perovskite film laminate 3 is wound in the annealing chamber 16, the stress of the perovskite can be relaxed while the perovskite film laminate 3 is wound. Since the temperature of the annealing chamber 16 is lower than the temperature of the crystallization chamber 15 and is higher than the ordinary temperature, the perovskite film is not rapidly cooled even when the perovskite film laminate 3 moves from the crystallization chamber 15 to the annealing chamber 16 and even when the perovskite film laminate 3 is taken out from the annealing chamber 16, and the cracks are less likely to occur in the perovskite film.

Further, it is possible to prevent deterioration of the perovskite film by controlling the humidity with the dehumidifier in the annealing chamber 16.

The perovskite film formation method of the present embodiment includes a step of removing the solvent from the solution coated onto the base material 1 without crystallizing the perovskite precursor, and a step of crystallizing the perovskite precursor on the base material 1 to form the perovskite film, after the step of removing the solvent. Accordingly, the removal of the solvent can be performed separately from the crystallization from the perovskite precursor to the perovskite, and the high-quality perovskite film having a uniform crystal structure and few defects can be formed.

### (11) Modifications

The above disclosure is merely an example, and various modifications can be made.

For example, the solvent removal chamber 14 may be provided with a blower that blows air at a temperature equal to or lower than the temperature of the solvent removal chamber 14 (for example, the ordinary temperature or a low temperature that does not cause dew condensation) toward the base material 1, and the temperature of the perovskite precursor on the base material 1 may be prevented from rising by the air from the blower.

Instead of indirectly cooling the base material 1 by cooling the conveyance rollers 30 in the solvent removal chamber 14, the base material 1 may be cooled in advance at a stage before the removal of the solvent in the solvent removal chamber 14.

Further, as long as the pressure adjustment chamber is capable of reducing the difference in the air pressure between the two adjacent areas in the front-rear direction, a specific configuration and a control method thereof may be different from the configuration and the control method of each of the pressure adjustment chambers 17, 18, and 19 described above.

Further, the winding shaft 50 may be disposed in front of the annealing chamber 16, and the base material 1 having passed through the annealing chamber 16 may be wound around the winding shaft 50. In this case, it can be said that the place where the winding shaft 50 is disposed is the winding unit.

Although one embodiment of the present invention has been described above, the embodiment has been presented by way of example only, and is not intended to limit the scope of the invention. These novel embodiments can be implemented in various other forms, and various omissions, substitutions, and changes can be made without departing from the spirit of the invention. These embodiments or their modifications are included in the invention described in the scope of claims and equivalents thereof, as well as being included in the scope and gist of the invention.

### Reference Signs List

- 1:: base material
- 2:: solution layer
- 3:: perovskite film laminate
- 10:: perovskite film formation apparatus
- 11:: unwinding unit
- 12:: surface treatment unit
- 13:: coating chamber
- 14:: solvent removal chamber
- 15:: crystallization chamber
- 16:: annealing chamber
- 17:: first pressure adjustment chamber
- 18:: second pressure adjustment chamber
- 19:: third pressure adjustment chamber
- 20:: winding shaft
- 21:: die
- 22:: backup roller
- 23:: air supply port
- 23a:: damper
- 24:: air exhaust port
- 24a:: damper
- 25a:: air pressure sensor
- 25b:: air pressure sensor
- 29:: partition wall
- 30:: conveyance roller
- 31:: infrared ray emission device
- 32a:: blower device
- 32b:: intake device
- 33:: roller cooling device
- 40:: conveyance roller
- 41:: nozzle
- 41a:: front outlet
- 41b:: rear outlet
- 42:: inlet
- 43:: air exhaust chamber
- 44:: air supply chamber
- 45:: air supply path
- 50:: winding shaft
- 51:: intake port
- 52:: discharge port
- 60:: control unit

## Claims

1. A perovskite film formation apparatus that crystallizes a perovskite precursor on a base material coated with a solution containing the perovskite precursor and a solvent to form a perovskite film, the perovskite film formation apparatus comprising:
as areas configured to allow the base material to be continuously conveyed to pass therethrough,
a solvent removal chamber serving as an area where the solution on the base material is heated to a temperature at which the solvent is evaporated and the perovskite precursor is not crystallized, thereby removing the solvent from the solution coated on the base material without crystallizing the perovskite precursor; and
a crystallization chamber serving as an area where the perovskite precursor is crystallized, on the base material having passed through the solvent removal chamber and from which the solvent is removed, by being heated to a crystallization temperature or higher to form the perovskite film, wherein
wavelengths of infrared rays to be absorbed by the solvent and the perovskite precursor are different from each other,
an infrared ray emission device for emitting the infrared ray having the specific wavelength to be absorbed by the solvent, is provided in the solvent removal chamber,
the infrared ray emission device emits the infrared ray having the specific wavelength toward the solution to heat the solution to the temperature at which the solvent is evaporated and the perovskite precursor is not crystallized, thereby evaporating and removing the solvent without crystallizing the perovskite precursor,
a conveyance roller for allowing the base material to be placed thereon and conveying the base material is provided in the solvent removal chamber,
the conveyance roller causes a surface coated with the solution to face upward and conveys the base material, and
a roller cooling device for cooling the conveyance roller is provided.

2. The perovskite film formation apparatus according to claim 1, further comprising:
an unwinding unit configured to unwind the base material before the solution is coated;
a coating chamber configured to coat the solution on the base material; and
a winding unit configured to wind the base material on which the perovskite film is formed, wherein
the solvent removal chamber and the crystallization chamber are sequentially provided as areas provided between the coating chamber and the winding unit.

3. The perovskite film formation apparatus according to claim 1 or 2, wherein
the solvent removal chamber is provided with
the conveyance roller for allowing the base material to be placed thereon and conveying the base material, and
a rectifying device provided above the conveyance roller and configured to send air in the same direction as a conveyance direction of the base material.

4. The perovskite film formation apparatus according to claim 1 or 2, wherein
in the crystallization chamber, the perovskite precursor after the solvent is removed is heated to the crystallization temperature or higher and is crystallized by blowing hot air from a plurality of nozzles.

5. The perovskite film formation apparatus according to claim 4, wherein
in the crystallization chamber, the plurality of nozzles each having an outlet for the hot air are arranged in a front-rear direction, and
an inlet for the air is provided between the adjacent nozzles.

6. The perovskite film formation apparatus according to claim 1 or 2, wherein
a pressure adjustment chamber is provided between the solvent removal chamber and the crystallization chamber, and
a difference between an air pressure in the solvent removal chamber and an air pressure in the crystallization chamber is controlled to be eliminated by intake and exhaust in the pressure adjustment chamber.

7. The perovskite film formation apparatus according to claim 1 or 2, wherein
an annealing chamber is provided as an area where the base material having passed through the crystallization chamber reaches, and
a temperature of the annealing chamber is lower than a temperature of the crystallization chamber and is higher than an ordinary temperature.

8. A perovskite film formation method that crystallizes a perovskite precursor on a base material coated with a solution containing the perovskite precursor and a solvent to form a perovskite film, the perovskite film formation method comprising:
a step of heating the solution on the base material to a temperature at which the solvent is evaporated and the perovskite precursor is not crystallized, thereby removing the solvent from the solution coated on the base material without crystallizing the perovskite precursor; and
a step of crystallizing the perovskite precursor, on the base material from which the solvent is removed, by heating the perovskite precursor to a crystallization temperature or higher to form the perovskite film, after the step of removing the solvent, wherein
wavelengths of infrared rays to be absorbed by the solvent and the perovskite precursor are different from each other,
in the step of removing the solvent, an infrared ray emission device emits the infrared ray having the specific wavelength to be absorbed by the solvent toward the solution to heat the solution, thereby evaporating and removing the solvent without crystallizing the perovskite precursor, and
the step of removing the solvent is performed when a conveyance roller allows the base material to be placed thereon and conveys the base material, in the step of removing the solvent, the conveyance roller causes a surface coated with the solution to face upward and conveys the base material, and cools the base material from a lower surface side.
